# EUROPEAN PATENT APPLICATION

(11) **EP 4 835 567 A1**
(43) Date of publication of application: **04.11.2026**
(21) Application number: 25204640.4
(22) Date of filing: 25.09.2025
(51) Int. Cl.: G03F 1/84, G03F 7/20, G21K 1/06

(54) **HIGH-PERFORMANCE EUV MICROSCOPE DEVICE WITH FREELY VARIABLE ILLUMINATION SYSTEM**

(30) Priority: 30.04.2025 KR 20250057718; 20.08.2025 KR 20250116063
(71) Applicant: E-SOL, Inc., Hwaseong-si, Gyeonggi-do 18487 (KR)
(72) Inventor: LEE, Dong Gun, 18440 Hwaseong-si, Gyeonggi-do (KR)
(74) Representative: M. Zardi & Co S.A.

(57) **Abstract**

The present invention relates to a high-performance EUV microscope device with a freely variable illumination system. In an EUV mask microscope device, it comprises: an EUV light source that outputs EUV light corresponding to a wavelength between 10 and 14 nm; an EUV mirror including an actuator to control the irradiation direction of the EUV light output from the said EUV light source; a focusing DOE (diffractive optical elements) for irradiating an EUV mask with the EUV light reflected from the said EUV mirror; a Zoneplate lens that generates diffracted light by diffracting the reflected light that has passed through the said focusing DOE and then reflected from the said EUV mask; and a detector that detects an image of the said EUV mask through the diffracted light from the said Zoneplate lens.

## Description

### BACKGROUND OF THE DISCLOSURE

### Cross Reference to Related Application of the Disclosure

The present application claims the benefit of Korean Patent Application No.10-2025-0116063 filed in the Korean Intellectual Property Office on AUG 20, 2025, No.10-2025-0057718 filed in the Korean Intellectual Property Office on APR 30, 2025
the entire contents of which are incorporated herein by reference.

### Field of the Disclosure

The present invention relates to a high-performance EUV microscope device with a freely variable illumination system, and more particularly, to a high-performance EUV microscope device with a freely variable illumination system for inspecting an EUV mask used in an EUV lithography process in a semiconductor device manufacturing process.

### Background of the Related Art

In the development of semiconductor technology, lithography is a very critical process. The era of applying EUV lithography technology with a wavelength of 13.5 nm has arrived from the conventional ArF lithography technology using a 193 nm wavelength, and it has become possible to perform more miniaturized processes by utilizing next-generation EUV lithography equipment.

EUV lithography technology in semiconductors is a technology for patterning fine semiconductor patterns on a wafer using a lithography apparatus composed of an EUV light source with a wavelength of 13.5 nm and an EUV optical system composed of multilayer mirrors.

An EUV lithography apparatus is composed of an optical system that illuminates an EUV mask with EUV light, and a projection optical system that projects a pattern image reflected from the EUV mask onto a wafer, and the resolution of the optical system is determined by the NA (numerical aperture) of the said projection optical system.

In the semiconductor industry, in order to achieve a higher resolution than the resolution determined by the NA of the said projection optical system and to increase the margin (process window) in the lithography process, the illumination optical system is also optimized, and one of these is the flex ray illumination system.

Mainly, the illumination optical system sometimes improves the overall wafer transfer resolution by applying Off-Axis Illumination (OAI) to the EUV mask, and recently, OAI with various angles or intensity distributions suitable for the pattern shape of the mask is being applied.

In order to correspond to different patterns for each mask, there is a need to adjust the angle or intensity distribution of the off-axis illumination light through software (s/w), and the technology that implements this is the flex ray illumination technology.

There is an industry demand to inspect by applying the flex ray illumination technology applied in a lithography tool to an EUV mask inspection tool, because performing inspection with the same illumination form has the advantage that the inspection result has good correlation with the inspection of the pattern exposed on the wafer.

However, since applying the expensive flex ray illumination technology for lithography tools to a mask inspection tool has the problem of increasing costs and the overall complexity of the system, an illumination shape modification technology using an aperture, which is expected to have a similar effect to flex ray illumination, is being applied in actual mask inspection tools.

The shape of the aperture can be made similar to flex ray illumination and applied, but this has two disadvantages.

First, in the aperture method, light passes only through the open part of the aperture, so all other light is lost. In an actual lithography tool, the area ratio of the part where light passes through the aperture is called 'pupil fill ratios (PFR)', and this value is used down to a minimum level of 20%. As a result, if an illumination with a PFR of 20% is applied using the aperture method, 80% of the light is lost.

The second disadvantage is that since the aperture only allows for the transmission and non-transmission of light (i.e., a combination of 1 and 0), it cannot implement the various intensity distributions that are being applied in actual lithography tools.

A technology that overcomes these problems of implementing an illumination system by the aperture type is disclosed in "Extreme ultraviolet microscope characterization using photomask surface roughness" published in NATURE's SCIENTIFIC REPORTS.

This technology constitutes an illumination system by combining a synchrotron radiation source, an illumination optical system composed of mirrors, and a MEMS mirror to implement flex-ray, and applies a Zoneplate lens for imaging. However, even when using such conventional technology, the number of mirrors and elements used increases, which leads to problems such as an increase in the manufacturing cost of each mirror and difficulty in aligning the entire illumination optical system.

### [Prior art Documents]

(Patent Document 1) US Patent No. 5,177,774
(Patent Document 2) US Patent No. 6,738,135
(Patent Document 3) US Published Patent Application No. 2023/0121350
(Patent Document 4) KR Patent No. 10-1370203
(Patent Document 5) KR Patent No. 10-1258344
(Patent Document 6) KR Patent No. 10-1606227

### SUMMARY OF THE DISCLOSURE

### [Technical Problem]

An object of the present invention for solving the above problems is to provide an inspection technology and an inspection method for an EUV Mask.

Another technical problem to be achieved by the present invention is to provide a high-performance EUV inspection technology by combining mirror steering and a diffractive optical element.

Still another technical problem to be achieved by the present invention is to provide a microscope apparatus that can optimize the quality of inspection illumination through the optimization of a diffractive optical element.

### [Solution to Problem]

To achieve the above objects, the present invention, in a microscope apparatus for an EUV mask, comprises: an EUV light source that outputs EUV light corresponding to a wavelength between 10 and 14 nm; an EUV mirror including an actuator to control the irradiation direction of the EUV light output from the said EUV light source; a focusing DOE (diffractive optical elements) for irradiating the EUV mask with the EUV light reflected from the said EUV mirror; a Zoneplate lens that generates diffracted light by diffracting the reflected light that has passed through the said focusing DOE and then reflected from the said EUV mask; and a detector that detects an image of the said EUV mask through the diffracted light from the said Zoneplate lens.

Further, the NA of the beam focused by the said focusing DOE is configured to be smaller than the maximum focusable NA of the said focusing DOE.

Further, in the said detector, the illumination light is irradiated along a t1 or t2 optical path by steering the said EUV mirror, and the light reaching the said detector is accumulated and detected by the said detector.

That is, as the illumination light is irradiated along the t1 optical path or the t2 optical path by steering the said EUV mirror, the light incident on the said t1 optical path or t2 optical path is gathered at a single point on the EUV mask due to the characteristics of the said Zoneplate.

Further, the said EUV mirror is configured as a flat mirror or an aspheric mirror.

Further, the said EUV mirror is configured with a combination of a flat mirror and a spherical mirror to simultaneously perform focusing and steering functions for focusing the EUV light.

Further, the said focusing DOE (Diffractive optic element) is composed of a Zoneplate lens.

Further, the said focusing DOE (Diffractive optic element) corresponds to a Zoneplate lens which is composed of a Square array, wherein the period and angle of the diffraction pattern within each Square are the same, and the beam diffracted from each square is designed to be directed to the same location.

Further, the said focusing DOE (Diffractive optic element) is a membrane-type diffractive optical element.

Further, the said Zoneplate lens is a membrane-type Zoneplate lens.

### [Advantageous Effects of Invention]

The present invention, configured and operating as described above, has the effect of providing stable illumination light to an EUV mask inspection apparatus.

In particular, the present invention has the effect of realizing the stability of field illumination and uniform illumination light, and consequently, illuminating with a stable beam shape.

### BRIEF DESCRIPTION OF THE DRAWINGS

FIG. 1 is an overall configuration diagram of a high-performance EUV microscope device with a freely variable illumination system according to the present invention.
FIG. 2 is a diagram of an embodiment of an EUV mirror in the high-performance EUV microscope device with a freely variable illumination system according to the present invention.
FIG. 3 is a detailed view of a focusing DOE in the high-performance EUV microscope device with a freely variable illumination system according to the present invention.
FIG. 4 is a diagram of an embodiment of a focusing DOE in the high-performance EUV microscope device with a freely variable illumination system according to the present invention.
FIG. 5 is another detailed view of a focusing DOE in the high-performance EUV microscope device with a freely variable illumination system according to the present invention.
FIG. 6 is a drawing showing a test image of an actual illumination device of the high-performance EUV microscope device with a freely variable illumination system according to the present invention.
FIG. 7 is a drawing showing the behavior of incident light of a Zoneplate according to the present invention.
FIG. 8 is a drawing showing the behavior of light in two optical paths according to the present invention.

### [Description of the Reference Numerals]

100: EUV light source
200: EUV mirror
210: Flat mirror
300: Focusing DOE (diffractive optical elements)
400: EUV mask
500: Zoneplate lens
600: Detector

### DETAILED DESCRIPTION OF THE PREFERRED EMBODIMENTS

Hereinafter, a high-performance EUV microscope device with a freely variable illumination system according to the present invention will be described in detail with reference to the accompanying drawings.

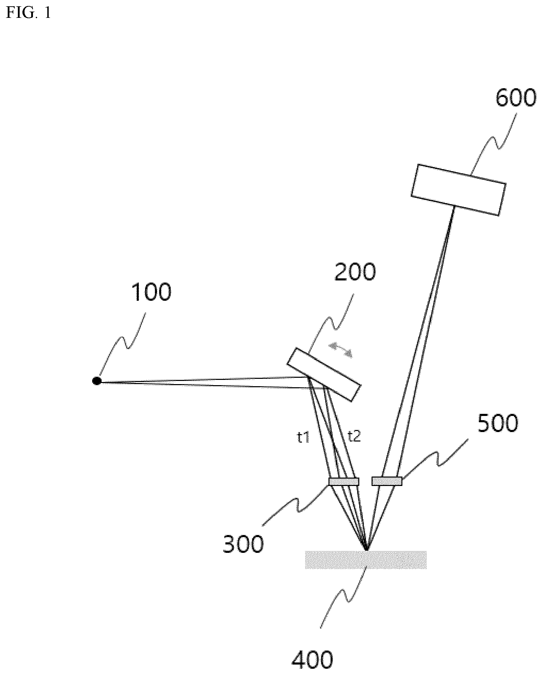

FIG. 1 is an overall configuration diagram of a high-performance EUV microscope device with a freely variable illumination system according to the present invention.

The microscope device according to the present invention is an inspection device for EUV mask inspection, and above all, it provides a microscope device that provides stability of illumination light while greatly simplifying the structure of the optical device.

To this end, as shown in FIG. 1, the present invention largely comprises an EUV light source (100), an EUV mirror (200) whose direction can be driven by an actuator, a diffractive optical element (DOE: diffractive optical elements, 300) for focusing and irradiating the illumination EUV light reflected from the said EUV mirror (200), a Zoneplate lens (500) that generates diffracted light by diffracting the reflected light from the EUV mask (400), and a detector (600) that detects the diffracted light.

The said EUV light source (100) is preferably composed of an EUV light source (100) that outputs EUV (Extreme ultraviolet) light corresponding to a wavelength between 10 and 14 nm. More preferably, EUV light having a wavelength of 13.5 nm can be used.

As mentioned earlier, the present invention is characterized by adjusting the angle of the beam incident on the illumination diffractive optical element (DOE: diffractive optical elements, 300) with a mirror equipped with an actuator to apply flex-ray illumination.

Accordingly, the said EUV mirror (200) applied in the present invention corresponds to a driving-type EUV mirror that is equipped with an actuator to control the reflection direction of the incident light from the said EUV light source (100). At this time, the said EUV mirror (200) may be composed of a single flat mirror or an aspheric mirror, or a combination of multiple mirrors, which will be described in detail below.

The said EUV mirror (200) can be composed of a combination of various mirrors, and a key technical feature is that the direction of the illumination light can be controlled by controlling the reflection direction through a combination with an actuator. For example, an actuator having a 6-degree-of-freedom function can be combined with the EUV mirror to control the reflection direction while driving.

Meanwhile, the diffractive optical element (300) according to the present invention is a focusing DOE (diffractive optical elements) for irradiating the EUV mask with the EUV light reflected from the said EUV mirror (200).

At this time, the NA of the beam entering the said focusing diffractive optical element (DOE 300) is configured to be smaller than the maximum NA that the corresponding DOE can focus.

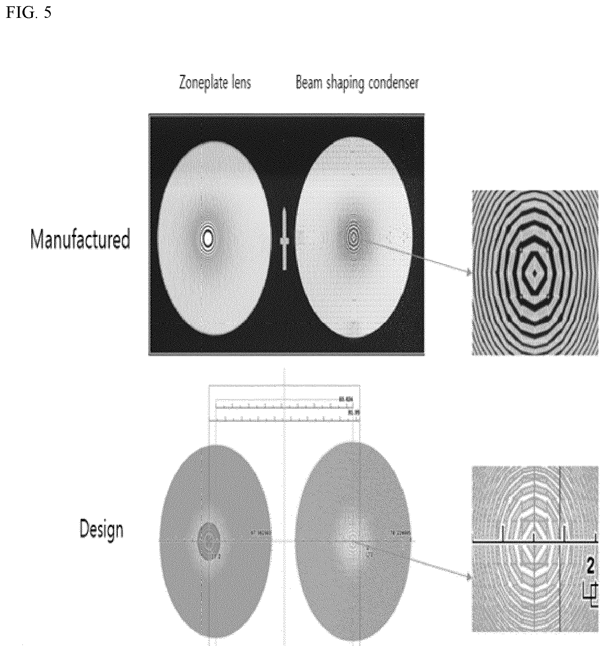

The said focusing diffractive optical element (300) can be implemented as a Zoneplate lens or a Beam shaping condenser lens. At this time, the beam shaping condenser lens is an optical element configured with the same period and angle of the diffraction pattern to deliver all diffracted beams to the same location, which will be described in detail later with reference to FIG. 5.

The illumination light transmitted through the said focusing DOE (300) is irradiated onto the EUV mask (400), which is the object of inspection, and the present invention includes a Zoneplate lens (500) for diffracting the light reflected from the said EUV mask to form an image on a detector.

The said Zoneplate lens (500) generates diffracted light by diffracting the reflected light from the said EUV mask (400).

Finally, the present invention includes a detector (600) that detects the image of the said EUV mask through the diffracted light from the said Zoneplate lens (500).

At this time, the said detector (600) is illuminated with illumination light as the said EUV mirror (200) is steered from t1 to t2, and accumulates and detects the light that has reached the said detector.

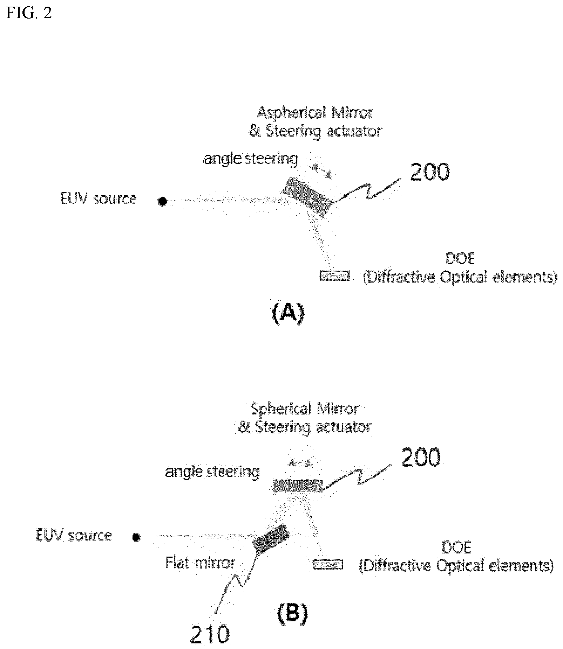

FIG. 2 is a diagram of an embodiment of an EUV mirror in the high-performance EUV microscope device with a freely variable illumination system according to the present invention.

As shown in FIG. 2, the said EUV mirror can be composed of a combination of several mirrors. For example, as in (A), it can be configured as a steerable structure by combining an actuator with a flat mirror or an aspheric mirror. Another example (B) is a configuration that combines a flat mirror and a spherical mirror to simultaneously perform the functions of focusing and steering EUV light, and in this case, it can be operated by coupling a driving actuator to the said spherical mirror.

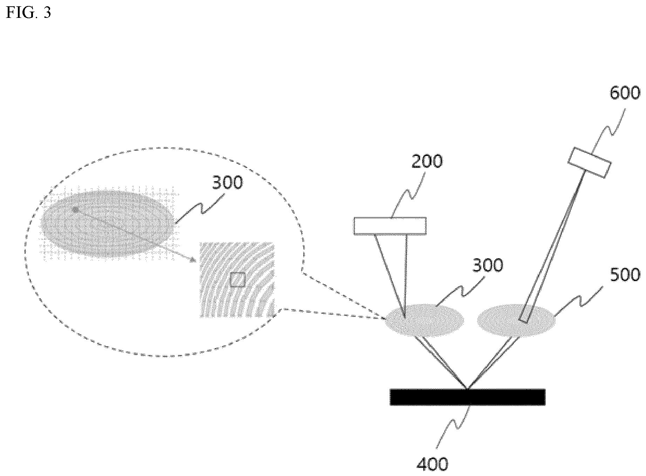

FIG. 3 is a detailed view of a focusing DOE in the high-performance EUV microscope device with a freely variable illumination system according to the present invention.

As the focusing diffractive optical element (DOE; Diffractive optic element) according to the present invention, a Zoneplate lens or a beam shaping Zoneplate lens can be used.

Here, a 'Beam shaping condenser Zoneplate lens' is a Zoneplate lens composed of a Square array and designed such that all diffracted beams are directed to the same location by making the period and angle of the diffraction pattern within each square the same.

The Zoneplate lens configured as such is manufactured by designing the period and angle of the diffraction pattern within the array to be the same, as shown in FIG. 5.

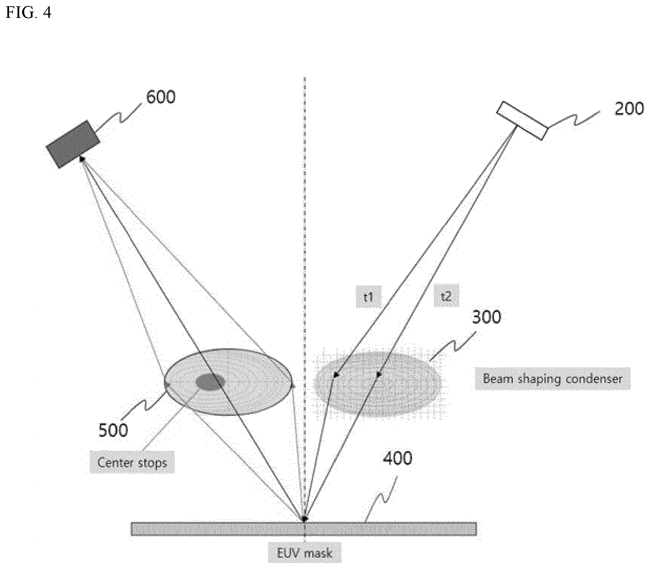

FIG. 4 is a diagram of an embodiment of a focusing DOE in the high-performance EUV microscope device with a freely variable illumination system according to the present invention.

The illumination light irradiated by steering the EUV mirror (200) from t1 to t2 passes through the focusing diffractive optical element (300), is reflected by the EUV mask (400), is diffracted again by the Zoneplate lens (500), and is acquired as an image by the detector (600).

FIG. 5 is another detailed view of a focusing DOE in the high-performance EUV microscope device with a freely variable illumination system according to the present invention.

As described above, the present invention includes a diffractive optical element (DOE: 300) that provides focusing illumination light and the said Zoneplate lens (500) that diffracts reflected light, respectively. At this time, the said focusing diffractive optical element (300) according to the present invention is composed of a Square array, and is designed and manufactured so that the period and angle of the diffraction pattern within each square are the same, thereby having a structure in which the beam diffracted from each square is directed to the same location.

That is, the said Zoneplate lens is configured in the form of a Square array, and by manufacturing the grating within each square array with the same diffraction conditions (the period of the diffraction pattern and the diffraction angle are the same), it is designed so that all diffracted beams are directed to a single focal point.

At this time, since the grating formed in each of the said square arrays is formed as a straight line rather than a curved line, it becomes a diffraction grating of the same interval in each section, so that CAD design or mask data generation can be processed simply.

Therefore, by appropriately setting the section size, it is possible to lower the manufacturing difficulty while minimizing the loss of focus quality.

Furthermore, it is preferable to control the area or diameter of the incident beam such that (A/20) < B < (A/4) or D/2 > d, where A represents the total area and D represents the diameter of the surface of the said Zoneplate lens on which the beam is incident, and B represents the area and d represents the diameter of the beam spot formed on the said surface by the incident beam.

That is, by steering the said EUV mirror, the angle of the beam incident on the focusing Zoneplate lens (300) can be changed. This means that even if the beam is incident on the same single point of the EUV mask, the incident angle of the beam reaching that point can be changed.

Through this, by changing the incident angle for various patterns of the EUV mask, more accurate inspection becomes possible.

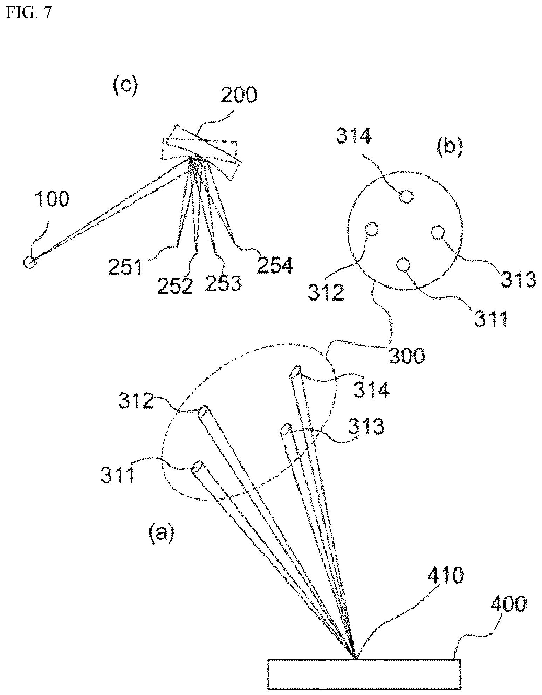

The structure for changing the incident angle of the beam incident on the EUV mask will be described with reference to FIG. 7. The beam incident from the EUV light source (100) to the said EUV mirror (200) is incident on the Zone plate lens (300) at various angles through the steering of the said EUV mirror.

That is, as shown in FIG. 7(c), by steering the EUV mirror, four directions of illumination light can be created: a downward illumination light (251), a leftward illumination light (252), a rightward illumination light (253), and an upward illumination light (254).

The illumination light formed with different incident angles in this way is incident on the Zoneplate lens, where the downward illumination light (251) is incident on the lower position (311) of the Zoneplate, the leftward illumination light (252) on the left position (312), the rightward illumination light (253) on the right position (313), and the upward illumination light (254) on the upper position (314), respectively.

Then, the said lower position light (311), left position light (312), right position light (313), and upper position light (314) all pass through the Zoneplate lens and are incident on the EUV mask, and at this time, these lights are all incident so as to gather at one focal point (410).

FIG. 7(a) is a perspective view of the Zone plate lens, and FIG. 7(b) is a plan view thereof. Through this, it can be seen that the lower position light (311), left position light (312), right position light (313), and upper position light (314) are lights incident on the upper, lower, left, and right positions, respectively, based on the center of the Zoneplate.

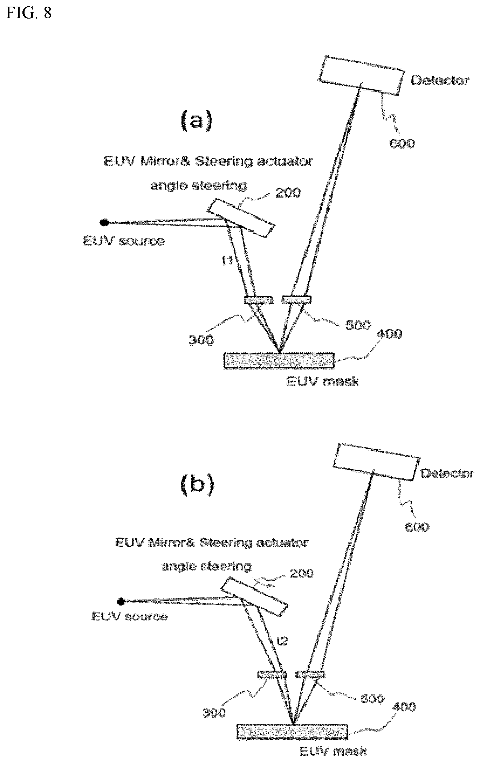

FIG. 8 shows the t1 optical path and the t2 optical path of FIG. 1, separated respectively.

By utilizing the diffractive optical element designed in this way, the present invention can illuminate the EUV mask with a stable beam shape.

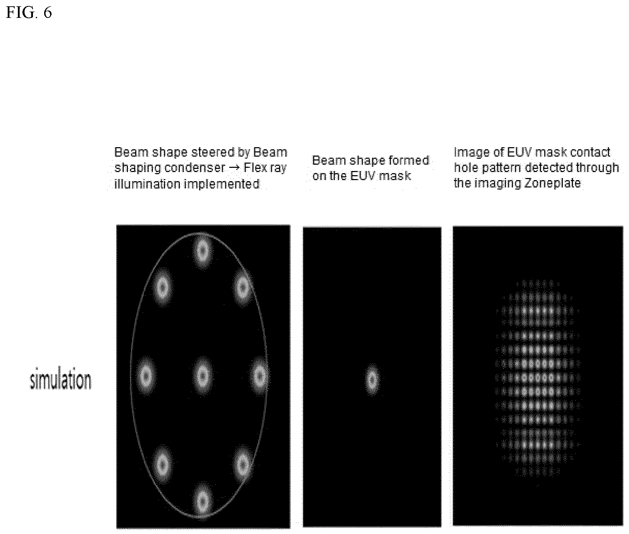

FIG. 6 is a drawing showing an actual test image of an illumination device implemented with a freely variable illumination system according to the present invention.

The first image in FIG. 6 shows the simulation result of the beam shape that can be formed with the diffractive optical element through the steering of the EUV mirror (200). The second image shows the single beam shape formed when the Flex ray illumination thus implemented is actually irradiated onto an EUV mask.

The third image is finally obtained by diffracting the light reflected from the said EUV mask through the Zoneplate lens (500), and it is an image showing the hole pattern of the EUV mask.

The present invention configured as such has the effect of providing stable illumination light to an EUV mask inspection apparatus.

In particular, the present invention secures the stability of field illumination and implements uniform illumination light, thereby having the effect of illuminating with a stable beam shape as a result.

While the present invention has been described and illustrated in connection with preferred embodiments for illustrating the principles of the present invention, it is not limited to the configurations and actions as shown and described. Rather, it will be well understood by those skilled in the art that numerous changes and modifications can be made to the present invention without departing from the spirit and scope of the appended claims. Therefore, all such appropriate changes, modifications, and equivalents should be considered to fall within the scope of the present invention.

## Claims

1. A high-performance EUV microscope device with a freely variable illumination system, for an EUV mask microscope device, comprising:
an EUV light source that outputs EUV light corresponding to a wavelength between 10 and 14 nm;
an EUV mirror including an actuator to control the irradiation direction of the EUV light output from the said EUV light source;
a focusing DOE (diffractive optical elements) for irradiating an EUV mask with the EUV light reflected from the said EUV mirror;
a Zoneplate lens that generates diffracted light by diffracting the reflected light that has passed through the said focusing DOE and then reflected from the said EUV mask; and
a detector that detects an image of the said EUV mask through the diffracted light from the said Zoneplate lens.

2. The high-performance EUV microscope device with a freely variable illumination system according to claim 1,
wherein the NA of the beam focused by the said focusing DOE is configured to be smaller than the maximum focusable NA of the said focusing DOE.

3. The high-performance EUV microscope device with a freely variable illumination system according to claim 1,
wherein illumination light is irradiated along a t1 or t2 optical path by steering the said EUV mirror, and the light that has reached the said detector is accumulated and detected.

4. The high-performance EUV microscope device with a freely variable illumination system according to claim 1,
wherein the said EUV mirror is composed of a flat mirror or an aspheric mirror.

5. The high-performance EUV microscope device with a freely variable illumination system according to claim 1,
wherein the said EUV mirror is composed of a combination of a flat mirror and a spherical mirror to simultaneously perform focusing and steering functions for focusing EUV light.

6. The high-performance EUV microscope device with a freely variable illumination system according to claim 5,
wherein the said focusing DOE (Diffractive optic element) is composed of a Zoneplate lens.

7. The high-performance EUV microscope device with a freely variable illumination system according to claim 6,
wherein the said Zoneplate lens is configured in the form of a Square array, and the grating of the said Zone plate is manufactured such that the diffraction direction of light within each square array is directed towards a single focal point, whereby the grating within each square array has the same diffraction condition of diffraction period and diffraction angle, so that all beams diffracted from each square array are designed to be directed to a single focal point location.

8. The high-performance EUV microscope device with a freely variable illumination system according to claim 7,
wherein the grating formed in each of the said square arrays is formed as a straight line rather than a curved line to lower the manufacturing difficulty.

9. The high-performance EUV microscope device with a freely variable illumination system according to claim 7,
wherein, when the total area of the surface where the beam is incident on the said Zoneplate lens is A, and the diameter is D, and the area of the beam formed on the surface of the said Zoneplate by the incident beam is B, and the diameter is d, the area or diameter of the incident beam is controlled such that (A/20) < B < (A/4) or D/2 > d.

10. The high-performance EUV microscope device with a freely variable illumination system according to claim 8,
wherein, with respect to the entire circumferential surface, which is the entire area from 0 degrees to 360 degrees based on the center of the incident surface of the said Zoneplate lens,
the beam incident on the said Zoneplate lens is controlled to be incident at any position on the said entire circumferential surface by the steering of the EUV mirror by the said actuator.

11. The high-performance EUV microscope device with a freely variable illumination system according to claim 1, wherein the said focusing DOE (Diffractive optic element) is a membrane-type diffractive optical element.

12. The high-performance EUV microscope device with a freely variable illumination system according to claim 1, wherein the said Zoneplate lens is a membrane-type Zoneplate lens.
